# EUROPEAN PATENT SPECIFICATION

(11) **EP 4 080 562 B1**
(45) Date of publication and mention of the grant of the patent: **19.03.2025**
(21) Application number: 22177689.1
(22) Date of filing: 30.07.2019
(51) Int. Cl.: H01L 23/473, H01L 23/373

(54) **COOLER**
KÜHLER
REFROIDISSEUR

(43) Date of publication of application: 26.10.2022
(62) Divisional of application: 19189127.4
(73) Proprietor: BRUSA Elektronik AG, 9466 Sennwald (CH)
(72) Inventor: Wendelspiess, Ueli, 9445 Rebstein (CH)
(74) Representative: Rösler Rasch van der Heide & Partner

(56) References cited:
- WO-A1-2018/123387
- CN-A- 105 514 064
- US-A1- 2014 168 901
- US-A1- 2019 393 132

## Description

### FIELD OF THE INVENTION

The present invention relates to a cooler, which in particular is adapted for cooling electronic structural units or assemblies.

### BACKGROUND OF THE INVENTION

As is known, the power dissipation and hence the heat evolution of electronic assemblies are increasing with the power-related further development of the electronic structural elements. It is true that these components are becoming smaller but their efficiencies are increasing and hence efforts to remove the thermal energy increase as well. Furthermore, due to their compactness, these electronic elements are positioned in a smaller space so that once again a higher local heat development results. The power dissipations achieved would be possible only with complicated and bulky cooling bodies when employing fan cooling and are therefore unacceptable. In case of large losses, air cooling therefore clearly reaches its limits.

The new high-performance processors deliver about 70 to 100 W over an area of about 10 cm² and thus achieve a far higher heat flux density. The processor manufacturers predict that a further increase in the waste heat is to be expected in the years ahead. In view of this development, those skilled in the art are considering liquid cooling for such applications. Liquid cooling more effectively dissipates the heat from the electronic assemblies, with the result that a higher power density is possible. Liquid coolers also allow more compact switch cabinets with numerous electronic components and operate very quietly.

An exemplary generic cooling apparatus is disclosed in EP 2 291 859 A1, in which an insert is provided inside a cooling channel, the insert having a plurality of pins forming channels towards a cooler wall and being supplied with coolant via openings in an inclined surface of the inlet which is hit by a coolant flow from the coolant channel.

The document CN 105 514 064 A discloses a radiator for cooling electronic components.

The document US 2014/0167901 A1 discloses a power module comprising a sealed body connected to a heat dissipating member for cooling semiconductors located inside the sealed body.

### OBJECT OF THE INVENTION

The invention provides an improved cooler, which, while being as compact as possible, permits a more effective cooling structure and a lighter, simpler design.

### SUMMARY OF THE INVENTION

The invention is set out in the appended set of claims.

### BRIEF DESCRIPTION OF THE DRAWINGS

By way of example only, preferred embodiments of the invention will be described more fully hereinafter with reference to the accompanying figures, wherein:
Figures 1 to 5 show different view of a first embodiment of a cooler according to the invention;
Figure 6 shows an abstracted view of a coolant flow through a cooler according to one embodiment of the invention;
Figures 7 to 11 show different possible aspects of embodiments of a cooler according to the invention;
Figures 12 to 14 show different views of a further embodiment of a cooler according to the invention;
Figure 15 shows a further modification of an embodiment of a cooler according to the invention;
Figures 16, 17 and 18 show a further varied aspect of an embodiment of a cooler according to the invention;
Figures 19 and 20 show different views of yet a further embodiment of a cooler according to the invention;
Figures 21 and 22 shows different views of yet another embodiment of a cooler according to the invention;
Figure 23 shows an exemplary configuration of how a part to be cooled is applied on the first plane;

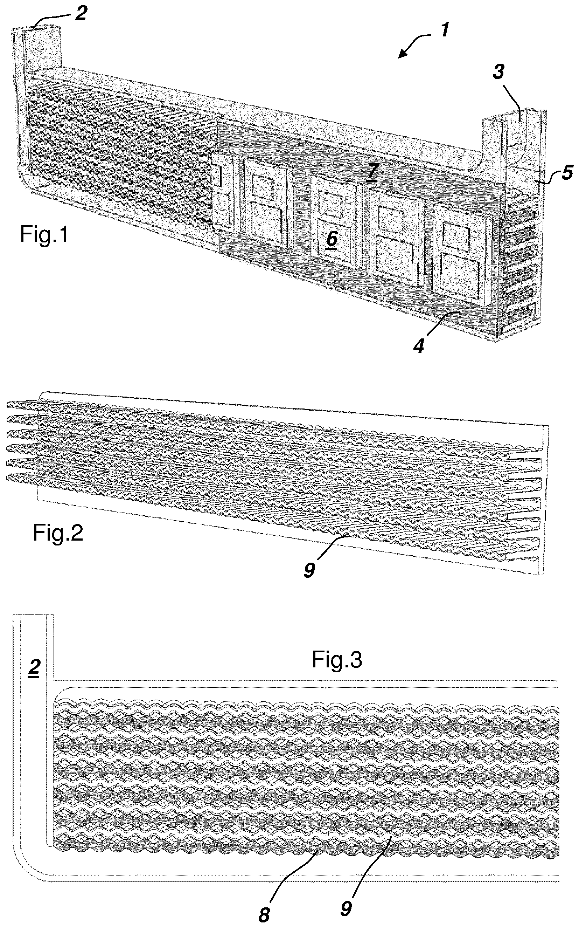

The embodiments described in relation with figures 1-18 do not form part of the invention but are useful to understand it.

### DETAILED DESCRIPTION OF THE DRAWINGS

Figure 1 shows a first embodiment of a cooler 1 according to the invention. The cooler 1 has an inlet 2 and an outlet 3, a first unit 4 and a second unit 5. A first part to be cooled 6, in particular an electronic element, is applied on a first surface 7 of the first unit 4. The cooler is fed by the inlet 2 with coolant, which distributes in a lower part of the cooler, more or less evenly along a long side of the cooler, and is then guided forth and back through a plurality of channels formed by fins of the first and second unit until it arrives in an upper part of the cooler which accesses the outlet 3 where the coolant is discharged. The formations of the inlet 2 and/or outlet 3 can be part of the first and/or second unit or can be separate elements connectable with the first and second unit. The first and second unit can together form a housing. In a particular embodiment, the first and second unit form a housing together with at least one of a separate inlet, a separate outlet, and a separate wall element.

In the example shown in figure 1, the fed coolant first comes into contact with a fin of the first unit. However, as well, the first fin to come into contact with the coolant can also be from the second unit. The fins of the first and second unit intertwine, i.e. they are put together such that the fins of the first unit and the second unit alternate. In this way, the coolant is sent forth and back, at every turn impinging on the backside of the plate having the first surface 7. The area of impinging is named "root" in the following. The term "intertwine" is to be interpreted as implying the involved units both (a) having at least in some parts contact and (b) having at least in some parts no contact at all.

To more easily understand the structure, figure 2 shows a section of the second unit of figure 1. It is noted that such structure is by way of example only. The inventive principle can also be achieved with various other structures, as will be shown below. The fins 9 in figure 2 ("second unit fins") have a waved profile. They extend from a root section ("second unit roots") to a front section ("second unit fronts").

Figure 3 shows a cross-sectional view along the long side and perpendicular to an alignment of the corrugated structure of the fins. In this situation, the first and second unit are stuck together, which is why the second unit fins 9 are visible here as well as first unit fins 8. A particular feature of the embodiment of figure 3 is that a longitudinal orientation of the fins a slight inclination in order to further improve an even longitudinal distribution of the coolant to achieve a uniform pressure drop. However, this inclination is optional and not necessary in all embodiments of the invention. Each of the corrugated structures has for example a waved pattern, a zigzag pattern, a meander pattern, or a trapezoidal pattern

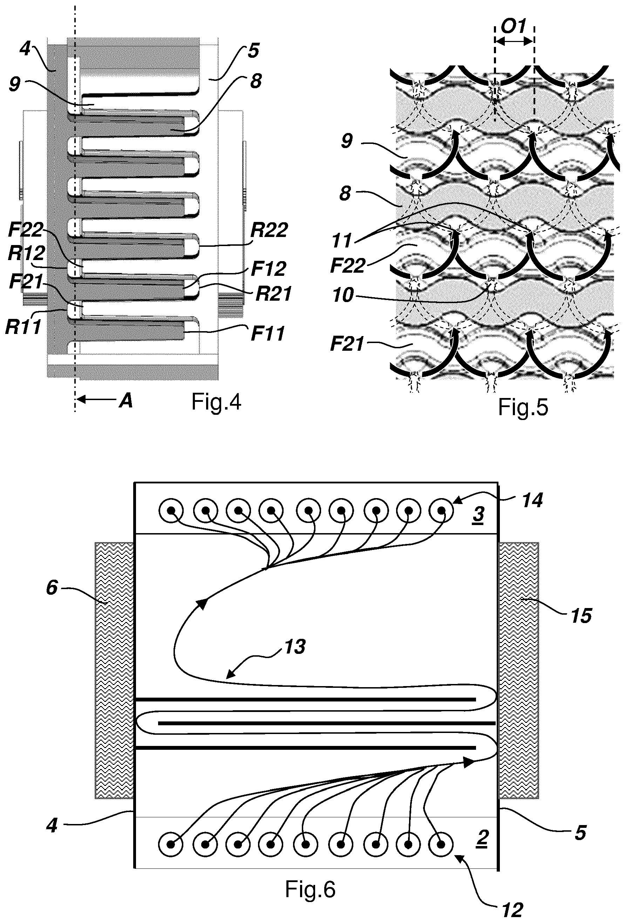

Figure 4 shows a side view such that the long side is essentially perpendicular to the paper level and one can see the single fins 8 of the first unit and the single fins 9 of the second unit being intertwined. The coolant by which the cooler is fed, arrives below the first fin of the first unit 8 on the bottom where it distributes along the long side. The coolant then finds its way around the front section F11 of said first fin to travel between said first fin of the first unit and the first fin of the second unit. This mechanism will be explained more generally for figure 6 below. Said travel between two fins takes place in channels which are formed with a corrugated structure on at least one of the participating fins.

Figure 5 shows an example for this formation of channels, which is in accordance with the structure of the fins in figures 1 to 4 where the fins of both of the first and second unit have a waved form. Figure 5 shows the cross-section view of figure 3 in greater detail from the first unit 4 towards the second unit 5. This cross-section view corresponds to the cut plane A indicated in figure 4. As can be seen in figure 5, the fins are arranged and abutting one another in such a way that said waves are offset relative to each other to form the channels. That is to say, the reverse channels are shifted by the offset O1 relative to the inbound channels.

A coolant flow is indicated by the full arrows and the dashed arrows. The full arrow flow could be seen from the perspective of the cutting plane A, the dashed arrow flow is a reverse flow actually covered by the fins from this perspective. So, the fins 8 are actually cut in this view, and from the fins 9 we can see the front section uncut. The area of full arrows is a root (section) of the first unit where a cooling impingement takes place. After the coolant coming from an inbound flow 10 frontally impinged on the root, it is split up into two flow parts laterally diverging into reverse channels 11 to the next "floor" or "level". This split-up of the single channel flows allows an extra cooling effect which increases the overall efficiency. Apart from the ever first inbound flow in the system, all other inbound flows are reverse flows from a respective preceding inbound flow.

An abstracted cross-sectional side view of the first embodiment is shown in figure 6. The arrow heads 12 indicate a direction from the paper level out of the plane and show an exemplary flow of coolant from the inlet feeding the cooler. The lines 13 indicate the flow progress of the coolant through the cooler, i.e. from the inlet 2 towards an outlet 3, wherein the arrow heads 14 again are directed out of the plane, i.e. perpendicular to the paper level, and indicate how the used coolant is discharged. Of course, the flowing direction of the coolant in the inlet relative to the outlet can also be opposed (from the top to the bottom). In particular, the flow direction in the inlet and/or the outlet is not necessarily perpendicular to the paper level in the view of figure 1. In this first embodiment, the cooler can cool two parts 6 and 15 which are arranged on planes of the units 4 and respectively 5. These part carrying planes are the opposite sides of the respective roots of the units (see R11, R12 and R21, R22 in figure 4). Figure 6 shows only two fins of the first unit 4 and second unit 5, however this only serves the illustration of the coolant flowing principle and of course the respective assemblies can comprise many more fins.

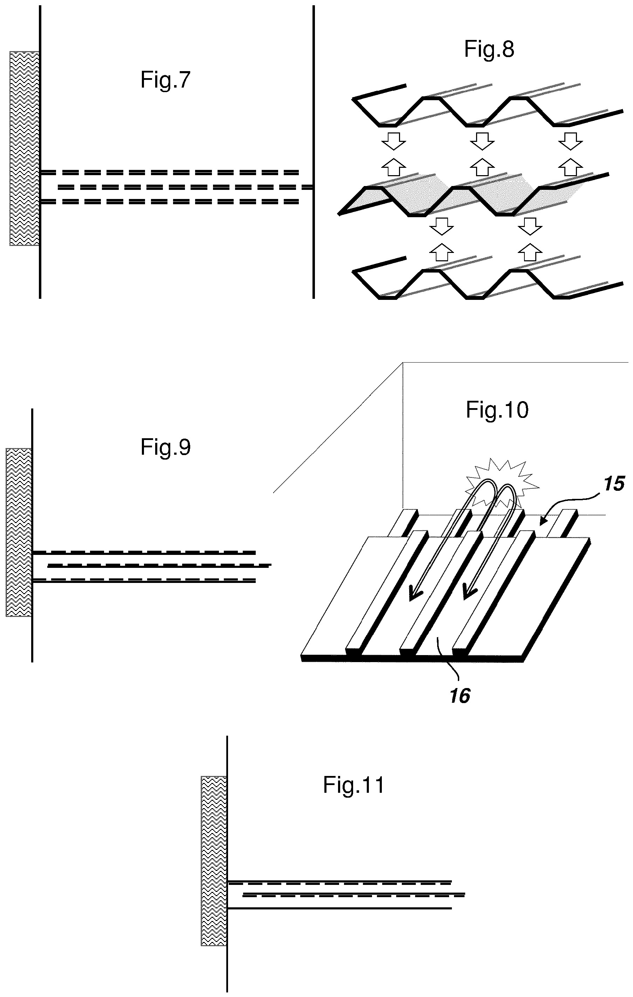

While figure 6 is undescriptive about which fins and/or which side of the fins has a corrugated structure, figures 7, 9, 11, 12, 14, and 15 show some of the various possibilities.

The corrugations of the embodiment according to figures 1 to 5 are represented by the layout of figure 7. The double dashed line means both sides of the fins have a corrugated structure, in this case a wave structure. A further possibility of a double-sided structure of fins in shown in figure 8, wherein the indentations are abutting in an assembled situation (indicated by the arrows). In other words, the structure is not necessarily rounded, it can also have an edged meander-type of shape. The sketches of figures 7, 9, 11,12, 15, 16, and 21 show the fins being spaced apart, however, these figures are only for demonstration of the constellations, not to show the true dimensions.

A further example is abstractedly shown in figure 9, where the fins are plates having a smooth surface on one side and having corrugations on the other side. One embodiment for this case is shown in the 3D view of figure 10, where the corrugated structure is achieved with grooves cut out from a plate, or with bars added to a plate. When the first unit fins and the second unit fins are contacting with an offset regarding their corrugations, they will form inbound channels 15 and reverse channels 16. The impingement on the root surface is indicated with the splash symbol and the split-up is indicated with the double-lined arrow showing the flowing direction of the coolant. Why figure 9 is undetermined about a second unit wall or root will be understood when arriving at another embodiment further below. Figure 11 shows an example of fin structures that corresponds to the example of figures 9 and 10 just the other way around.

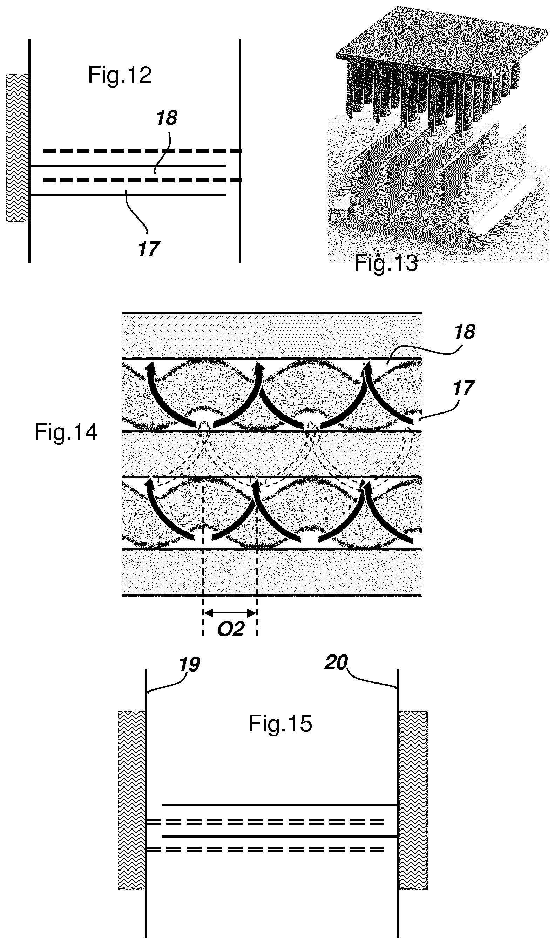

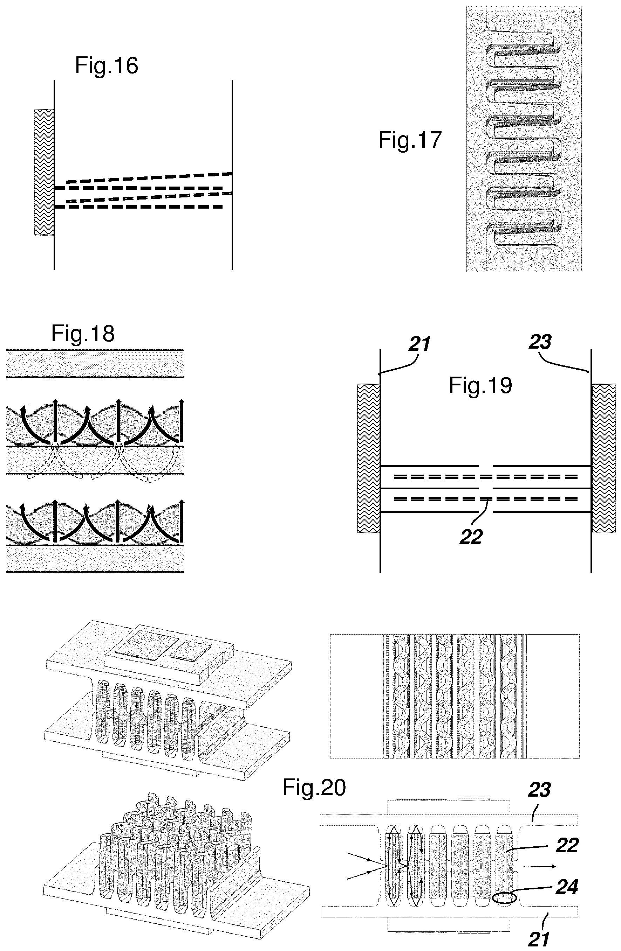

A further embodiment of a combination of first and second unit of a cooler is shown with figures 12, 13, and 14, where the second unit can be of a material that is cheaper to manufacture, e.g. plastic. The first unit having a surface for receiving a part to be cooled can be made of a material that has very good thermal conductivity, e.g. aluminium. Machining aluminium with smooth fins is easier compared to the waved-structured fins shown in figures 1 to 5. Figure 12 shows on the left said first unit with the smooth plates and on the right the second unit, which (can be, but here) is not intended for receiving a part to be cooled, having a double-sided corrugated structure. The fins of the first and second unit are abutting at least such that the form an inbound channel 17. In particular, the channel 17 is at least formed in the area of the second unit fin front, i.e. shortly before the coolant is entering the root area to impinge on the first unit wall. Figure 14 shows an example how the fins are abutting and how the coolant is redirected. The reverse channels 18 are in this case also starting right at the second unit fronts where the first unit fins are abutting. It would be possible to keep some distance for the reverse flow such that no reverse "channels" are formed but a reverse flow (see Figure 18). It must be noted that most importantly, it is the inbound coolant which is formed by channels in order to impinge on the root area in the form of a jet that will split up or broaden or swirl after it impinged on the root. In the shown example (figure 14), the reverse flow is immediately introduced in reverse channels 18 which are arranged offset to the inbound channels 17. This channel offset O2 is to be understood with reference to an axis which is aligned perpendicular to the channels and parallel to the fins.

Figure 15 shows a similar constellation, wherein only the first unit 19 has double-sided structured fins and the second unit has plain fins and a second surface for receiving electronics to cool. A person of skill in the art will see that there are various possibilities to apply the inventive principle.

Figure 16 shows in an exaggerated sketch that the fins of the first unit have an inclination relative to the fins of the second unit. This is shown with the example of each of the units having double-sidedly structured fins, however other structure constellations may be applicable. Figure 17 shows this inclination with a side view of intertwining fins. The inbound channels are only formed shortly before the coolant hits the impingement zone (root) at the respective root. As a result, after impinging, the coolant is not introduced into a reverse channel. However, the inbound channels forming little jets that can impinge on the root still leads to an advantageous cooling effect according to the invention. After impinging, the coolant is whirled around generating turbulences. Figure 18 shows how the reverse flow is entering an open duct instead of the offset channels as known from the other embodiments.

Figures 19 and the four parts of figure 20 show an embodiment with a first unit 21, a second unit 22, and a third unit 23. The second unit is in this case an insert 22 having a both-sidedly corrugated structure. As second unit 22 counts every structured fin that is inserted into the cavities (so not only the one labelled in figure 19, but the whole set). This set of fins 22 can be clamped between the first and second unit 21, 23. To fix the second unit 22 without clogging the root section, said assemblies 21, 23 may have shoulders 24 for the fronts of the second unit to abut. However, other means such as notches on the fins of the second unit 22 could also be another embodiment for fixating the second unit 22 in the assembly. Due to the shoulders 24, the waved fins keep a gap to the roots such that the coolant can flow through the construction as indicated in the lower right part of figure 20. The coolant is fed between the first unit 21 and the third unit 23 and splits up into the shown two opposing directions towards the first unit first root and the third unit first root. The second unit 22 fins abutting the fins of the first and third unit forms channels in which the coolant is flowing. After impinging on the respective root it flows back on the other side of the second unit fin where channels are formed, too. At the area where the coolant now confronting, it distributes to the next "floor" or "storey", i.e. it flows around the second fins of the first and third unit, where the second unit second fin is again forming inbound channels. This embodiment is also relatively simple to machine while still providing the inventive principle. For example, as second unit, a plastic injection moulding part can be used since it does not need to necessarily have a good thermal conductivity and its purpose is mainly to form the inbound channels and the reverse channels offset to the inbound channels.

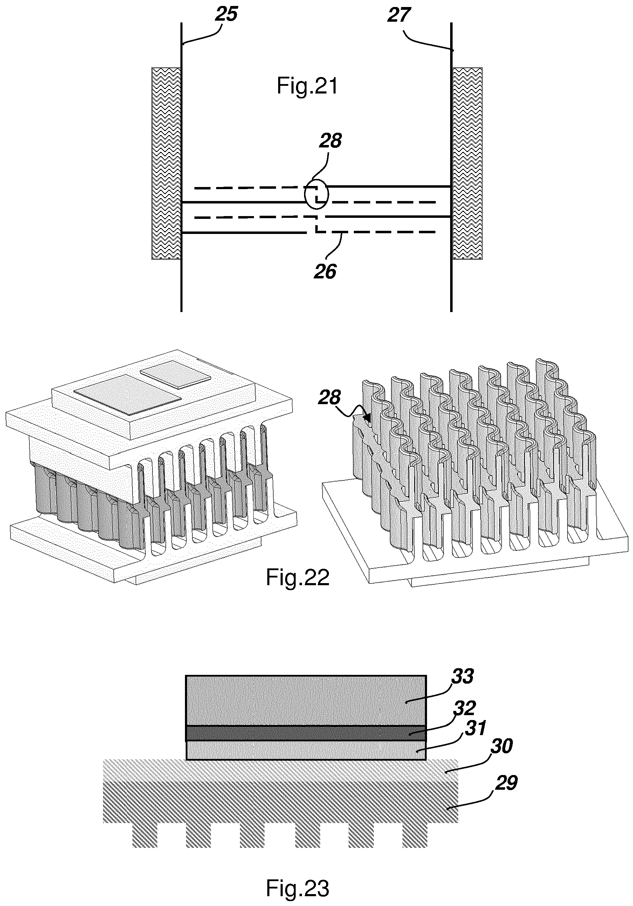

Another embodiment is shown with figures 21 and 22, where a second unit 26 is a set of corrugated sheets each having a bend in the middle. The first unit 25 and the third unit 27 are similar to the ones from the embodiment of figures 19 and 20, i.e. ribbed aluminium parts, with the difference that they are arranged offset relative to each other such that the fins can each rest on one of said bends in the second unit fins. In the area of each bend of the second unit fins there is an opening 28 for conducting the coolant. In this way, the coolant is guided through this labyrinth in the inventive manner wherein upon impinging the coolant flow is split apart and discharged from the root area in offset reverse channels.

Whatever way the cooler according to the invention might be embodied, a part to be cooled can be applied with the following configuration. The heatsink can be coated with thermally sprayed ceramic as electrical insulation. Between the ceramic layer and the heatsink, an intermediate layer can be applied to relieve the thermal stresses. The semiconductor device (=part to be cooled) can be mounted by means of a thermal paste and a mechanical fixation or by thermally conductive adhesives. With this special attachment, the electronic part is electrically isolated but the generated heat can be dissipated very effectively.

An exemplary configuration is shown in figure 23. The first unit 29 has on the opposite site of the roots (where the cooling impingement takes place) the surface to receive the part to be cooled 33. Said surface may have a coating 30 which is flame-sprayed and only 100 - 300 micrometer thin. For example, such coating is made of Al₂O₃ or AIN. Intermediate layer 31 is optional and can consist of a copper-based material. Thermal conductive layer 32 can for example be a glue, paste, or wax which is thermally conductive. This solution avoids the manufacturing step of soldering and allows for lesser interfaces compared to solutions known in the art.

## Claims

1. A cooler comprising an inlet, an outlet, a first unit (21), a second unit (22) and a third unit (23),
- the inlet configured for feeding the cooler with coolant,
- the outlet configured for discharging said coolant,
- the first unit (21) comprising a first plane for receiving a first part to be cooled and a set of first unit fins forming cavities,
- the third unit (23) comprising a set of third unit fins forming cavities,
- the second unit (22) - embodied as insert - having a set of second unit fins (22) inserted into the cavities formed by the sets of the first and the third unit fins,
- the second unit fins (22) each having a second unit fins first surface and a second unit fins second surface,
- the insert (22) having a both-sidedly corrugated structure,
- the second unit fins (22) abutting the first and the third unit fins forming inbound channels - between the second unit fins first surface and the first and the third unit fins - and forming reverse channels - between the second unit fins second surfaces and the first and the third unit fins - in such a way that
∘ the inbound channels being configured for
▪ forming coolant inbound flows towards roots of the first unit and the third unit and
▪ causing the coolant flows to impinge and laterally widen on the roots of the first unit and the third unit
∘ and that the reverse channels being configured for
▪ forming coolant back-flows after impinging on the respective roots.

2. The cooler according to claim 1, wherein the set of second unit fins (22) comprises fins being both-sidedly corrugated structured, this giving the insert (22) the both-sidedly corrugated structure, in particular wherein the second unit fins (22) are waved fins.

3. The cooler according to claim 1 or 2, wherein the set of second unit fins (22) is clamped between the first unit (21) and the third unit (23).

4. The cooler according to one of claims 1 to 3, wherein the first and third unit (21, 23) have shoulders (24) for fronts of the second unit (22) to abut, such as to fix the second unit (22) without clogging the respective roots.

5. The cooler according to one of claims 1 to 4, wherein the inbound channels and the reverse channels are formed (by the second unit fins (22) abutting the first and the third unit fins) such that there are several storeys.

6. The cooler according to claim 5, wherein the inbound channels and reverse channels (formed by the second unit fins (22) abutting the first and the third unit fins) are configured such that, after the coolant is flowing back, at an area where the coolant is confronting, the coolant is distributed to inbound channels of a respective next storey.

7. The cooler according to one of claims 1 to 6, wherein
- the first unit fins extend from the root of the first unit to first unit fins fronts,
- the first plane is in uninterrupted thermal contact with the root of the first unit, and
- the first unit fins each have a first unit fins first surface and a first unit fins second surface,

8. The cooler according to one of claims 1 to 7, wherein the third unit (23) also comprises a plane for receiving a second part to be cooled, wherein
- the plane is in uninterrupted thermal contact with the root of the third unit,
- the third unit fins extend from the root of the third unit to third unit fins fronts, and
- the third unit fins each have a third unit fins first surface and a third unit fins second surface.

9. The cooler according to one of claims 1 to 8, wherein
- the second unit fins have second unit fins first fronts and second unit fins second fronts, the second unit fins second fronts opposing the second unit fins first fronts,
- the second unit fins are located in part between the first unit fins and in part between the third unit fins such that
o the root of the first unit is adjacent to the second unit fins first fronts leaving first gaps and
o the root of the third unit is adjacent to the second unit fins second fronts leaving third gaps.

10. The cooler according to one of claims 1 to 9, wherein
- the first reverse channels are offset relative to the first inbound channels, and
- each of two neighbouring first reverse channels, which are closest to the first inbound channel, are configured for
o receiving a part of the impinged and widened first coolant inbound flow and
o forming a first coolant reverse flow from the root of the first unit towards the first unit fins fronts.

11. The cooler according to any of the preceding claims,
- the cooler being an electronic element cooler and
- the first part to be cooled being an electronic element.

12. The cooler according to any of the preceding claims, with at least one of the following further features:
- the second unit is of a plastic material,
- the first unit and the third unit being a finned component of a material containing aluminium,
- the root of the first unit being one side of a heat-conducting cooler wall and the first plane being an opposite side of the heat-conducting cooler wall,
- the first unit and the third unit are configured for forming a housing.

13. The cooler according to any of the preceding claims,
- the root of first unit being configured for causing a split-up of the coolant inbound flows into two part-flows,
- the two part-flows entering two neighbouring reverse channels.

## Patentansprüche

1. Kühler, welcher einen Einlass, einen Auslass, eine erste Einheit (21), eine zweite Einheit (22) und eine dritte Einheit (23) umfasst, wobei
- der Einlass dafür ausgelegt ist, dem Kühler Kühlmittel zuzuführen,
- der Auslass dafür ausgelegt ist, das Kühlmittel abzuführen,
- die erste Einheit (21) eine erste Ebene zum Aufnehmen eines ersten zu kühlenden Teils und einen Satz von Lamellen der ersten Einheit, die Hohlräume bilden, umfasst,
- die dritte Einheit (23) einen Satz von Lamellen der dritten Einheit, die Hohlräume bilden, umfasst,
- die zweite Einheit (22), als Einsatz ausgebildet, einen Satz von Lamellen der zweiten Einheit (22) aufweist, die in die Hohlräume eingesetzt sind, die von den Sätzen der Lamellen der ersten und der dritten Einheit gebildet werden,
- die Lamellen der zweiten Einheit (22) jeweils eine erste Fläche der Lamellen der zweiten Einheit und eine zweite Fläche der Lamellen der zweiten Einheit aufweisen,
- der Einsatz (22) eine beidseitig gewellte Struktur aufweist,
- die Lamellen der zweiten Einheit (22) an den Lamellen der ersten und der dritten Einheit anliegen, wobei sie nach innen gerichtete Kanäle bilden - zwischen der ersten Fläche der Lamellen der zweiten Einheit und den Lamellen der ersten und der dritten Einheit - und Rückkanäle bilden - zwischen den zweiten Flächen der Lamellen der zweiten Einheit und den Lamellen der ersten und der dritten Einheit -, auf eine solche Weise, dass
o die nach innen gerichteten Kanäle ausgelegt sind zum
▪ Bilden von nach innen gerichteten Kühlmittelströmen zu Wurzeln der ersten Einheit und der dritten Einheit und
▪ Bewirken, dass die Kühlmittelströme auf die Wurzeln der ersten Einheit und der dritten Einheit auftreffen und sich dort seitlich ausweiten,
∘ und dass die Rückkanäle ausgelegt sind zum
▪ Bilden von Kühlmittelrückströmen nach dem Auftreffen auf die jeweiligen Wurzeln.

2. Kühler nach Anspruch 1, wobei der Satz von Lamellen der zweiten Einheit (22) Lamellen umfasst, die beidseitig gewellt strukturiert sind, wobei dies dem Einsatz (22) die beidseitig gewellte Struktur verleiht, wobei insbesondere die Lamellen der zweiten Einheit (22) gewellte Lamellen sind.

3. Kühler nach Anspruch 1 oder 2, wobei der Satz von Lamellen der zweiten Einheit (22) zwischen die erste Einheit (21) und die dritte Einheit (23) geklemmt ist.

4. Kühler nach einem der Ansprüche 1 bis 3, wobei die erste und dritte Einheit (21, 23) Ansätze (24) zur Anlage für Vorderseiten der zweiten Einheit (22) aufweisen, um die zweite Einheit (22) zu fixieren, ohne die jeweiligen Wurzeln zu verstopfen.

5. Kühler nach einem der Ansprüche 1 bis 4, wobei die nach innen gerichteten Kanäle und die Rückkanäle so ausgebildet sind (durch die an den Lamellen der ersten und der dritten Einheit anliegenden Lamellen der zweiten Einheit (22)), dass mehrere Etagen vorhanden sind.

6. Kühler nach Anspruch 5, wobei die nach innen gerichteten Kanäle und Rückkanäle (die durch die an den Lamellen der ersten und der dritten Einheit anliegenden Lamellen der zweiten Einheit (22) gebildet werden) derart ausgebildet sind, dass, nachdem das Kühlmittel zurückströmt, in einem Bereich, wo das Kühlmittel anströmt, das Kühlmittel auf nach innen gerichtete Kanäle einer jeweiligen nächsten Etage verteilt wird.

7. Kühler nach einem der Ansprüche 1 bis 6, wobei
- die Lamellen der ersten Einheit sich von der Wurzel der ersten Einheit zu Vorderseiten der Lamellen der ersten Einheit erstrecken,
- die erste Ebene sich in ununterbrochenem thermischem Kontakt mit der Wurzel der ersten Einheit befindet und
- die Lamellen der ersten Einheit jeweils eine erste Fläche der Lamellen der ersten Einheit und eine zweite Fläche der Lamellen der ersten Einheit aufweisen.

8. Kühler nach einem der Ansprüche 1 bis 7, wobei die dritte Einheit (23) ebenfalls eine Ebene zum Aufnehmen eines zweiten zu kühlenden Teils umfasst, wobei
- die Ebene sich in ununterbrochenem thermischem Kontakt mit der Wurzel der dritten Einheit befindet,
- die Lamellen der dritten Einheit sich von der Wurzel der dritten Einheit zu Vorderseiten der Lamellen der dritten Einheit erstrecken und
- die Lamellen der dritten Einheit jeweils eine erste Fläche der Lamellen der dritten Einheit und eine zweite Fläche der Lamellen der dritten Einheit aufweisen.

9. Kühler nach einem der Ansprüche 1 bis 8, wobei
- die Lamellen der zweiten Einheit erste Vorderseiten der Lamellen der zweiten Einheit und zweite Vorderseiten der Lamellen der zweiten Einheit aufweisen, wobei die zweiten Vorderseiten der Lamellen der zweiten Einheit den ersten Vorderseiten der Lamellen der zweiten Einheit gegenüberliegen,
- die Lamellen der zweiten Einheit sich teilweise zwischen den Lamellen der ersten Einheit und teilweise zwischen den Lamellen der dritten Einheit befinden, so dass
o die Wurzel der ersten Einheit zu den ersten Vorderseiten der Lamellen der zweiten Einheit benachbart ist, wobei erste Lücken gelassen werden, und
o die Wurzel der dritten Einheit zu den zweiten Vorderseiten der Lamellen der zweiten Einheit benachbart ist, wobei dritte Lücken gelassen werden.

10. Kühler nach einem der Ansprüche 1 bis 9, wobei
- die ersten Rückkanäle in Bezug auf die ersten nach innen gerichteten Kanäle versetzt sind und
- jeder von zwei benachbarten ersten Rückkanälen, die dem ersten nach innen gerichteten Kanal am nächsten sind, ausgelegt ist zum
o Aufnehmen eines Teils des aufgetroffenen und ausgeweiteten ersten nach innen gerichteten Kühlmittelstroms und
o Bilden eines ersten Kühlmittelrückstroms von der Wurzel der ersten Einheit zu den Vorderseiten der Lamellen der ersten Einheit.

11. Kühler nach einem der vorhergehenden Ansprüche,
- wobei der Kühler ein Kühler für elektronische Elemente ist und
- wobei das erste zu kühlende Teil ein elektronisches Element ist.

12. Kühler nach einem der vorhergehenden Ansprüche mit wenigstens einem der folgenden weiteren Merkmale:
- die zweite Einheit besteht aus einem Kunststoff,
- die erste Einheit und die dritte Einheit sind eine Komponente mit Lamellen aus einem Material, das Aluminium enthält,
- die Wurzel der ersten Einheit ist eine Seite einer wärmeleitenden Kühlerwand die erste Ebene ist eine gegenüberliegende Seite der wärmeleitenden Kühlerwand,
- die erste Einheit und die dritte Einheit sind dafür ausgelegt, ein Gehäuse zu bilden.

13. Kühler nach einem der vorhergehenden Ansprüche,
- wobei die Wurzel der ersten Einheit dafür ausgelegt ist, eine Aufteilung der nach innen gerichteten Kühlmittelströme in zwei Teilströme zu bewirken,
- wobei die zwei Teilströme in zwei benachbarte Rückkanäle eintreten.

## Revendications

1. Refroidisseur comprenant une entrée, une sortie, une première unité (21), une deuxième unité (22) et une troisième unité (23),
- l'entrée étant configurée pour alimenter le refroidisseur en liquide de refroidissement,
- la sortie étant configurée pour évacuer ledit fluide de refroidissement,
- la première unité (21) comportant un premier plan de réception d'une première pièce à refroidir et un ensemble formant des cavités d'ailettes de première unité,
- la troisième unité (23) comprenant un ensemble formant des cavités d'ailettes de troisième unité,
- la deuxième unité (22) - réalisée sous forme d'insert - présentant un ensemble d'ailettes de deuxième unité (22) insérées dans les cavités formées par les ensembles d'ailettes de première et troisième unités,
- les ailettes de deuxième unité (22) ayant chacune une première surface d'ailettes de deuxième unité et une deuxième surface d'ailettes de deuxième unité,
- l'insert (22) ayant une structure ondulée sur les deux côtés,
- les ailettes de deuxième unité (22) venant en butée contre les ailettes de première et troisième unités formant des canaux entrants - entre la surface des ailettes de deuxième unité et les ailettes de première et troisième unités - et formant des canaux de retours - entre les surfaces d'ailettes de deuxième unité et les ailettes de première et troisième unités - de telle sorte que
∘ les canaux entrants soient configurés pour
▪ former des flux entrants de fluide de refroidissement vers les racines de la première unité et de la troisième unité et
▪ faire en sorte que les flux de liquide de refroidissement empiètent et s'élargissent latéralement sur les racines de la première unité et de la troisième unité
∘ et que les canaux de retours soient configurés pour
▪ former des reflux de liquide de refroidissement après empiètement sur les racines respectives.

2. Refroidisseur selon la revendication 1, dans lequel l'ensemble d'ailettes de deuxième unité (22) comprend des ailettes ont une structure ondulée des deux côtés, ce qui donne à l'insert (22) la structure ondulée des deux côtés, les ailettes de deuxième unité (22) étant en particulier des ailettes ondulées.

3. Refroidisseur selon la revendication 1 ou 2, dans lequel l'ensemble d'ailettes de deuxième unité (22) est serré entre la première unité (21) et la troisième unité (23).

4. Refroidisseur selon l'une des revendications 1 à 3, dans lequel les première et troisième unités (21, 23) ont des épaulements (24) pour que les fronts de la deuxième unité (22) viennent buter, de manière à fixer la deuxième unité (22) sans obstruer les racines concernées.

5. Refroidisseur selon l'une des revendications 1 à 4, dans lequel les canaux d'entrée et les canaux de retours sont formés (par les ailettes de deuxième unité (22) venant en butée contre les ailettes de première et troisième unités), de telle sorte qu'il y ait plusieurs étages.

6. Refroidisseur selon la revendication 5, dans lequel les canaux d'entrée et les canaux de retour (formés par les ailettes de deuxième unité (22) venant en butée contre les ailettes de première et troisième unités) sont configurés pour que, après le retour du fluide de refroidissement, au niveau d'une zone où le fluide de refroidissement est en regard, le fluide de refroidissement soit réparti dans les canaux d'entrée d'un étage suivant correspondant.

7. Refroidisseur selon l'une des revendications 1 à 6, dans lequel
- les ailettes de première unité s'étendent de la racine de la première unité aux fronts des ailettes de première unité,
- le premier plan est en contact thermique ininterrompu avec la racine de la première unité, et
- les ailettes de première unité ont chacune une première surface d'ailette de première unité et une seconde surface d'ailette de première unité,

8. Refroidisseur selon l'une des revendications 1 à 7, dans lequel la troisième unité (23) comprend également un plan pour recevoir une deuxième pièce à refroidir, dans lequel
- le plan est en contact thermique ininterrompu avec la racine de la troisième unité,
- les ailettes de troisième unité s'étendent de la racine de la troisième unité aux fronts des ailettes de troisième unité, et
- les ailettes de troisième unité ont chacune une première surface d'ailette de troisième unité et une seconde surface d'ailette de troisième unité.

9. Refroidisseur selon l'une des revendications 1 à 8, dans lequel
- les ailettes de deuxième unité ont des premiers fronts d'ailettes de deuxième unité et des seconds fronts d'ailettes de deuxième unité, les seconds fronts d'ailettes de deuxième unité étant opposés aux premiers fronts d'ailettes de deuxième unité ;
- les ailettes de deuxième unité sont situées en partie entre les ailettes de première unité et en partie entre les ailettes de troisième unité de telle sorte que
∘ la racine de la première unité soit adjacente aux premiers fronts des ailettes de deuxième unité en laissant des premiers espaces et
∘ la racine de la troisième unité soit adjacente aux seconds fronts des ailettes de deuxième unité en laissant des troisièmes espaces.

10. Refroidisseur selon l'une des revendications 1 à 9, dans lequel
- les premiers canaux de retours sont décalés par rapport aux premiers canaux entrants, et
- chacun des deux premiers canaux de retours voisins qui sont les plus proches du premier canal entrant est configuré pour
∘ recevoir une partie du premier flux entrant de liquide de refroidissement empiétant et élargi et
∘ former un premier flux de retour de liquide de refroidissement à partir de la racine de la première unité vers les fronts des ailettes de première unité.

11. Refroidisseur selon l'une quelconque des revendications précédentes,
- le refroidisseur étant un refroidisseur d'élément électronique et
- la première pièce à refroidir étant un élément électronique.

12. Refroidisseur selon l'une quelconque des revendications précédentes, présentant au moins l'une des autres caractéristiques suivantes :
- la deuxième unité est en matière plastique,
- la première unité et la troisième unité étant des éléments à ailettes en matériau contenant de l'aluminium,
- la racine de la première unité étant un côté d'une paroi de refroidisseur thermoconductrice et le premier plan étant un côté opposé de la paroi de refroidisseur thermoconductrice,
- la première unité et la troisième unité sont configurées pour former un boîtier.

13. Refroidisseur selon l'une quelconque des revendications précédentes,
- la racine de la première unité étant configurée pour provoquer une scission des flux entrants de liquide de refroidissement en deux flux partiels,
- les deux flux partiels entrant dans deux canaux de retour voisins.
